# EUROPÄISCHE PATENTSCHRIFT

(11) **EP 3 033 777 B1**
(45) Veröffentlichungstag und Bekanntmachung des Hinweises auf die Patenterteilung: **26.07.2017**
(21) Anmeldenummer: 14758071.6
(22) Anmeldetag: 30.07.2014
(51) Int. Cl.: H01L 51/00, C09B 57/00

(54) **VERFAHREN ZUM AUFBRINGEN EINER ORGANISCHEN HALBLEITERSCHICHT AUF DER BASIS VON EPINDOLIDION AUF EINEN TRÄGER**
METHOD FOR APPLYING AN ORGANIC SEMICONDUCTOR LAYER BASED ON EPINDOLIDIONE TO A CARRIER
PROCÉDÉ D'APPLICATION SUR UN SUPPORT D'UNE COUCHE SEMI-CONDUCTRICE ORGANIQUE À BASE D'EPIN-DOLIDIONE

(30) Priorität: 14.08.2013 AT 505042013
(43) Veröffentlichungstag der Anmeldung: 22.06.2016
(73) Patentinhaber: Universität Linz, 4040 Linz (AT)
(72) Erfinder: GLOWACKI, Eric Daniel, A-4020 Linz (AT); VOSS, Gundula, 95447 Bayreuth (DE)
(74) Vertreter: Patentanwaltskanzlei Hübscher
(86) Internationale Anmeldenummer: PCT/AT2014/050169
(87) Internationale Veröffentlichungsnummer: WO 2015/021490

(56) Entgegenhaltungen:
- US-A- 5 593 788
- Wilma Thür: "Epindolidione, Epindoline und lineare sowie trigonale Imidazolderivate - Neue Materialien mit interessanten Fluoreszenzeigenschaften", Dissertation zur Erlangung des Doktorgrades., 1. Januar 2001 (2001-01-01), XP055148694, München Gefunden im Internet: URL:http://edoc.ub.uni-muenchen.de/374/1/T huer_Wilma.pdf [gefunden am 2014-10-24]

## Beschreibung

Die Erfindung bezieht sich auf ein Verfahren zum Aufbringen einer organischen Halbleiterschicht auf der Basis von Epindolidion auf einen Träger.

Aufgrund ihrer Lichtechtheit und ihrer Unlöslichkeit, die auf Wasserstoffbrückenbildungen zurückzuführen sind, werden Epindolidione insbesondere als Farbpigmentstoffe eingesetzt (US 2005048406 A1, US 7 307 170 B2, US 5 811 156 A). Außerdem wurde bereits vorgeschlagen (JP H10189246 A), die Fluoreszenzeigenschaften der Epindolidione für ihren Einsatz als organische Halbleiter für Einrichtungen mit Elektrolumineszenzeigenschaften zu nützen, was jedoch im Hinblick auf die weitgehende Unlöslichkeit der Epindolidione zu Schwierigkeiten führt.

Darüber hinaus ist die Verwendung von Epindolidionen in OLEDs und organischen Solarzellen bekannt (WilmaThür:"Epindolidione, Epindoline und lineare sowie trigonale Imidazolderivate - Neue Materialien mit interessanten Fluoreszenzeigenschaften", Dissertation zur Erlangung des Doktorgrades, 2001, XP055148694, München), wobei darauf hingewiesen wird, dass für diese Anwendungen eine gute Löslichkeit in organischen Lösungsmitteln notwendig ist, dass aber Epindolidione durch Unlöslichkeit gekennzeichnet sind, die auf inter- und intramolekulare Wasserstoffbrückenbindungen zurückzuführen ist. Zur Verbesserung der Löslichkeit von Epindolidionverbindungen wird eine Alkylierung am Stickstoff vorgeschlagen.

Der Erfindung liegt somit die Aufgabe zugrunde, die Eigenschaften der Substanzklasse der Epindolidione als organischer Halbleiter zu nützen, ohne deren sich insbesondere auf ihre Unlöslichkeit beziehenden Nachteile vor allem hinsichtlich einer dünnschichtigen Aufbringung auf einen Träger in Kauf nehmen zu müssen.

Die Erfindung löst die gestellte Aufgabe dadurch, dass das Epindolidion zunächst mit tert-Butyloxycarbonyl als Schutzgruppe zu tert-Butyloxycarbonylepindolidion umgesetzt und dann in einem Lösungsmittel gelöst wird, bevor das gelöste tert-Butyloxycarbonylepindolidion auf den Träger aufgebracht wird, und dass dann das Lösungsmittel verdampft und die tert-Butyloxycarbonyl-Schutzgruppe wieder abgespalten wird.

Die Erfindung beruht auf der Erkenntnis, dass tert-Butyloxycarbonylepindolidione vergleichsweise einfach in verschiedenen Lösungsmitteln gelöst werden können, was das Aufbringen der jeweils geforderten Halbleiterschicht auf einem Träger erleichtert und mit für das Aufbringen von Dünnschichten in flüssiger Form herkömmlichen Verfahren durchgeführt werden kann. Da nach einem Verdampfen des Lösungsmittels die tert-Butyloxycarbonyl-Schutzgruppen wieder abgespalten werden können, bleibt auf dem Träger eine weitgehend unlösliche organische Halbleiterschicht auf der Basis von Epindolidion bestehen, wobei sich in überraschender Weise herausgestellt hat, dass die über den Umweg der löslichen tert-Butyloxycarbonylepindolidione auf einen Träger aufgebrachten Epindolidione im Vergleich zu der Substanzklasse der unmittelbar abgelagerten Epindolidione merklich verbesserte photophysikalische Eigenschaften aufweisen.

Die Epindolidione können sowohl mit einer als auch mit zwei tert-Butyloxycarbonyl-Schutzgruppen als N-tert-Butyloxycarbonylepindolidion oder als N,N'-Bis(tert-Butyloxycarbonyl)epindolidion eingesetzt werden.

Wie bereits ausgeführt wurde, sind nach dem Verdampfen des Lösungsmittels aus der auf den Träger aufgebrachten Schicht des mit wenigstens einer tert-Butyloxycarbonyl-Schutzgruppe versehenen Epindolidions die Schutzgruppen wieder abzuspalten, um die erwünschte, weitgehend unlösbare organische Halbleiterschicht zur Verfügung zu stellen. Zu diesem Zweck können die lösungsmittelfreien tert-Butyloxycarbonylepindolidione einer Pyrolyse durch eine Wärmezufuhr unterworfen werden, wobei die Erwärmungstemperatur je nach Anwendungsfall zwischen 80 und 250 °C betragen kann. Nach dem Abspalten der Schutzgruppe bzw. der Schutzgruppen liegen wieder die die Stabilität der Halbleiterschicht bestimmenden inter- und intramolekularen Wasserstoffbrückenbindungen vor.

Eine andere Möglichkeit zur Abspaltung der wenigstens einen Schutzgruppe besteht darin, dass die tert-Butyloxycarbonylepindolidion-Schicht nach dem Verdampfen des Lösungsmittels mit einem Säuredampf behandelt wird, wobei bevorzugt der Dampf der Trifluoressigsäure eingesetzt werden kann, obwohl es durchaus möglich ist, hierfür andere Säuredämpfe , z. B. den Dampf der Salzsäure, einzusetzen. Die Behandlung der auf einen Träger aufgebrachten tert-Butyloxycarbonylepindolidion-Schicht mit Säuredampf kann außerdem durch Wärmezufuhr unterstützt werden.

Zum Lösen der tert-Butyloxycarbonylepindolidione können unterschiedliche Lösungsmittel verwendet werden. Typische Lösungsmittel können einzeln oder in Kombination aus einer Lösungsmittelgruppe ausgewählt werden, die Chloroform, Chlorbenzol, Toluol, Dichlormethan, Cyclohexan und Aceton enthält.

Zur Herstellung von N,N'-Bis(tert-butyloxycarbonyl)epindolidion und N-tert-Butyloxycarbonylepindolidion wurde gemäß einem Ausführungsbeispiel von einem Epindolidion mit der folgenden Strukturformel ausgegangen:

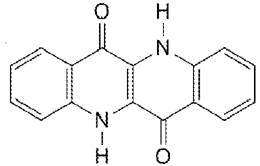

100 mg (0,38 mmol) dieses Epindolidions wurde mit 414 mg (1,9 mmol) Di-tert-butyldicarbonat (t-BOC₂O) und 93 mg (0,76 mmol) N,N'-Dimethylaminopyridin (DMAP) in 30 ml trockenem Tetrahydrofuran gemischt, wobei das Gemisch 3 Tage unter einer Stickstoffatmosphäre gerührt wurde. Danach wurde das Lösungsmittel unter vermindertem Druck verdampft. Der Rückstand wurde durch 30 g Kieselgel mit Toluol/Ethylacetat (9:1) gefiltert.

Die nichtpolaren Fraktionen enthielten 162 mg (19 %) N,N'-Bis(tert-butyloxycarbonyl)epindolidion (Bis-BOC-Epindolidion) als gelben Feststoff mit einer Strukturformel:

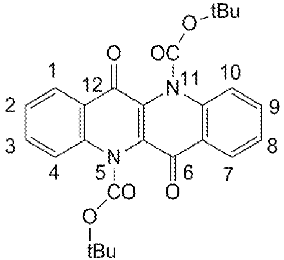

R_{f} = 0,57 (Toluol/Ethylacetat, 9:1), Probenzersetzungstemperatur 221,3 °C (43,6 %; theor. für 2 Isobuten/2 CO₂: 43,2 %). IR: unter anderen 3006 (vw, C-Hₐᵣ), 2987, 2937 (alle w, C-Hₐₗ), 1758 (s, C=O_{BOC}), 1623 (s, C=O_{ring}), 1606 (s), 1477 (s). ¹H-NMR (CDCl₃): 1,75 (s, 18 H), 7,43 (*t, J* = 8 Hz, 2 H), 7,78 (*t, J* = 8 Hz, 2 H), 7,92 (*d, J* = 8 Hz, 2 H), 8,47 (*d, J* = 8 Hz, 2 H). ESI-MS: unter anderen 501,20 (31, *M*K⁺), 485,13 (52, MNa⁺), 463,07 (42, *M*H⁺), 363,07 (60 [MH - CO₂, - C₄H₈]⁺), 307 (100 [MH - 2 CO₂ - C₄H₈)]⁺), 263 (38 [M - 2 CO₂, - 2 C₄H₈]⁺). gefunden: C 67,09, H 5,57, N 5,41 %. Berechnet für C₂₆H₂₆N₂O₆: C 67,52, H 5,67, N 6,06 %.

Die Verdampfung der polaren Fraktionen ergab 144 mg (76%) N-tert-Butyloxycarbonylepindolidion (Mono-BOC-Epindolidion) mit einer Strukturformel:

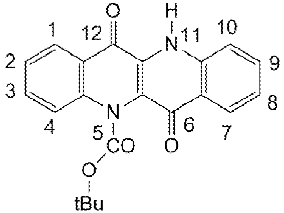

Rf = 0,20 (Toluol/Ethylacetat, 9:1), Probenzersetzungstemperatur 214,0 °C (27,6 %; theor. für Isobuten/CO₂: 27.9 %). IR: unter anderen 3241 (s, N-H), 1755 (s, C=O_{BOC}), 1602 (s), 1577 (s), 1489 (s). ¹H-NMR (300 MHz, CDCl₃/(D₆)DMSO): 1,77 (s, 9 H), 7,38 (t, J = 8 Hz, 1 H), 7,45 (t, J = 8 Hz, 1 H), 7,57 (d, J = 8 Hz, 1 H), 7,76 (t, J = 8 Hz, 1 H), 7,8 - 7,9 (2 H), 8,47 (d, J = 8 Hz, 1 H), 8,55 (d, J = 8 Hz, 1 H), 9,45 (s, 1 H, N-H). ESI-MS: unter anderen 747,20 (100, 2MNa⁺), 401,00 (7, MK⁺), 385,07 (26, MNa⁺), 363,07 (71, MH⁺), 307 (43, [MH -C₄H₈)]⁺), 263 (47 [M - CO₂,-C₄H₈]⁺). Gefunden: C 69,00, H 4,96, N 7,27 %. Berechnet für C₂₁H₁₈N₂O₄: C 69,60, H 5,01, N 7,73%.

Zum Herstellen eines Dünnschichthalbleiters aus einem der tert-Butyloxycarbonylepindolidione wird das Mono-BOC-Epindolidion bzw. das Bis-BOC-Epindolidion mit einem Lösungsmittel, z. B. Chloroform, gemischt und die erhaltene Lösung mit einem für einen Nassauftrag üblichen Beschichtungsverfahren auf einem Träger abgeschieden. Um die fertige, aufgrund inter- und intramolekularer Wasserstoffbrückenbindungen stabile Halbleiterschicht zu erhalten, ist zunächst das Lösungsmittel zu verdampfen, bevor die jeweiligen Schutzgruppen abgespalten werden können. Das Abspalten der Schutzgruppen kann durch eine Erwärmung der Schicht des Mono-BOC-Epindolidions bzw. des Bis-BOC-Epindolidions auf eine Temperatur von 80 bis 250 °C durchgeführt werden. Nach einer solchen Pyrolyse liegt die jeweilige organische Halbleiterschicht vor.

Mit Hilfe des geschilderten Beschichtungsverfahrens können beispielsweise organische lichtemittierende Dioden hergestellt werden, bei denen die aktive Halbleiterschicht zwischen einer transparenten Leiterschicht und einer leitenden Reflexionsschicht vorgesehen ist. Zu diesem Zweck kann z. B. eine Lösung des Bis-BOC-Epindolidions im Schleuderguss auf ein mit einem Indiumzinnoxid (ITO) beschichtetes Glassubstrat als Träger dünnschichtig aufgetragen werden. Nach einem Verdampfen des Lösungsmittels kann die Pyrolyse bei 150 °C durchgeführt werden, bevor eine leitende Deckschicht aus Aluminium aufgedampft wird.

In analoger Weise können mit Hilfe der erfindungsgemäßen organischen Halbleiter andere elektronische Vorrichtungen, wie Feldeffekttransistoren oder Photovoltaikelemente, hergestellt werden.

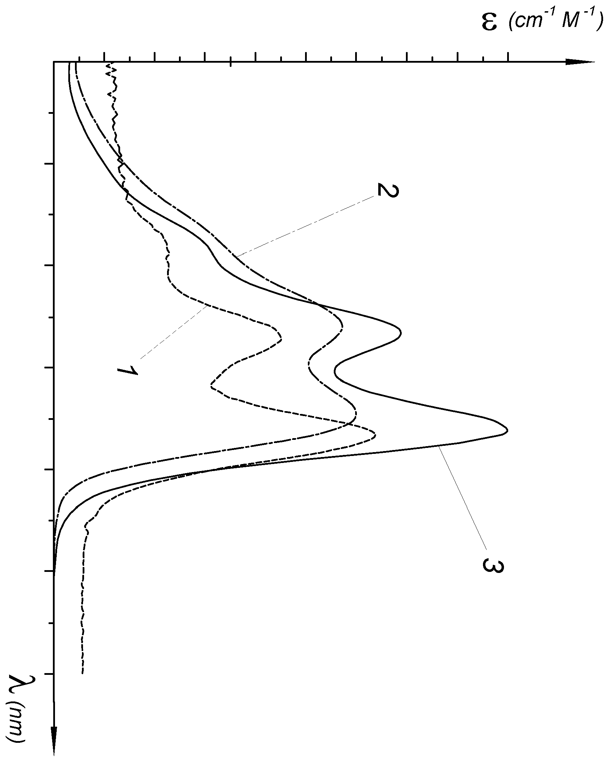

In der Zeichnung werden die photoelektrischen Eigenschaften der erfindungsgemäßen Halbleiter denen eines unmittelbar auf einen Träger aufgebrachten Epindolidions gegenübergestellt, und zwar anhand der auf der Ordinate aufgetragenen molaren Absorption ε [cm⁻¹M⁻¹] als Funktion von der auf der Abszisse aufgetragenen Wellenlänge λ [nm]. Dabei entspricht die strichliert gezeichnete Kennlinie 1 der molaren Absorption eines unmittelbar aufgebrachten Epindolidions, während die strichpunktiert gezeichnete Kennlinie 2 einer Halbleiterschicht zugehört, die über den Umweg eines gelösten Mono-BOC-Epindolidions erhalten wurde. Die mit einer vollen Linie dargestellte Kennlinie 3 zeigt die Absorptionseigenschaften einer Epindolidion-Schicht, die über den Umweg einer Lösung eines Bis-BOC-Epindolidions auf einem Träger aufgebracht wurde. Aus der Darstellung ergeben sich unmittelbar die unterschiedlichen Absorptionseigenschaften.

## Patentansprüche

1. Verfahren zum Aufbringen einer organischen Halbleiterschicht auf der Basis von Epindolidion auf einen Träger, **dadurch gekennzeichnet, dass** das Epindolidion zunächst mit tert-Butyloxycarbonyl als Schutzgruppe zu tert-Butyloxycarbonylepindolidion umgesetzt und dann in einem Lösungsmittel gelöst wird, bevor das gelöste tert-Butyloxycarbonylepindolidion auf den Träger aufgebracht wird, und dass dann das Lösungsmittel verdampft wird und die tert-Butyloxycarbonyl-Schutzgruppen wieder abgespalten werden.

2. Verfahren nach Anspruch 1, **dadurch gekennzeichnet, dass** das Epindolidion mit zwei tert-Butyloxycarbonyl-Schutzgruppe als N,N'-Bis(tert-Butyloxycarbonyl)epindolidion eingesetzt wird.

3. Verfahren nach Anspruch 1, **dadurch gekennzeichnet, dass** das Epindolidion mit einer tert-Butyloxycarbonyl-Schutzgruppe als N-tert-Butyloxycarbonylepindolidion eingesetzt wird.

4. Verfahren nach einem der Ansprüche 1 bis 3, **dadurch gekennzeichnet, dass** die tert-Butyloxycarbonyl-Schutzgruppen durch eine Erwärmung der auf den Träger aufgebrachten Schicht aus dem tert-Butyloxycarbonylepindolidion abgespalten werden.

5. Verfahren nach einem der Ansprüche 1 bis 4, **dadurch gekennzeichnet, dass** die tert-Butyloxycarbonyl-Schutzgruppen durch eine Behandlung der auf den Träger aufgebrachten Schicht mit Säuredampf aus dem tert-Butyloxycarbonylepindolidion abgespalten werden.

6. Verfahren nach Anspruch 5, **dadurch gekennzeichnet, dass** als Säuredampfeine verdampfte Trifluoressigsäure eingesetzt wird.

7. Verfahren nach einem der Ansprüche 1 bis 6, **dadurch gekennzeichnet, dass** als Lösungsmittel für das tert-Butyloxycarbonylepindolidion wenigstens ein Lösungsmittel aus der Chloroform, Chlorbenzol, Toluol, Dichlormethan, Cyclohexan und Aceton enthaltenden Lösungsmittelgruppe eingesetzt wird.

## Claims

1. Method for applying an organic semiconductor layer based on epindolidione to a carrier, **characterised in that** the epindolidione is first reacted with tert-butyloxycarbonyl as protective group to produce tert-butyloxycarbonyl epindolidione and is then dissolved in a solvent before the dissolved tert-butyloxycarbonyl epindolidione is applied to the carrier, and **in that** the solvent then is evaporated and the tert-butyloxycarbonyl protective groups are then detached.

2. Method as claimed in claim 1, **characterised in that** the epindolidione is used with two tert-butyloxycarbonyl protective groups as N,N'-bis(tert-butyloxycarbonyl)-epindolidione.

3. Method as claimed in claim 1, **characterised in that** the epindolidione is used with one tert-butyloxycarbonyl protective group as N-tert-butyloxycarbonyl epindolidione.

4. Method as claimed in any one of claims 1 to 3, **characterised in that** the tert-butyloxycarbonyl protective groups are detached from the tert-butyloxycarbonyl epindolidione by heating the layer which is applied to the carrier.

5. Method as claimed in any one of claims 1 to 4, **characterised in that** the tert-butyloxycarbonyl protective groups are detached from the tert-butyloxycarbonyl epindolidione by treating the layer, which is applied to the carrier, with acid vapour.

6. Method as claimed in claim 5, **characterised in that** an evaporated trifluoroacetic acid is used as the acid vapour.

7. Method as claimed in any one of claims 1 to 6, **characterised in that** at least one solvent from the solvent group containing chloroform, chlorobenzene, toluene, dichloromethane, cyclohexane and acetone is used as the solvent for the tert-butyloxycarbonyl epindolidione.

## Revendications

1. Procédé d'application sur un support d'une couche organique semiconductrice à base d'epin-dolidione, **caractérisé en ce que** l'epin-dolidione est tout d'abord convertie en tert-butyloxycarbonyle epin-dolidione avec du tert-butyloxycarbonyle comme groupe de protection, puis dissoute dans un solvant avant l'application de la tert-butyloxycarbonyle epin-dolidione dissoute sur le support, et **en ce que** le solvant est ensuite évaporé et les groupes de protection tert-butyloxycarbonyle sont à nouveau détachés.

2. Procédé selon la revendication 1, **caractérisé en ce que** l'epin-dolidione est utilisée avec deux groupes de protection tert-butyloxycarbonyle comme la N,N'-bis(tert-butyloxycarbonyle)epin-dolidione.

3. Procédé selon la revendication 1, **caractérisé en ce que** l'epin-dolidione est utilisée avec un groupe de protection tert-butyloxycarbonyle comme la N-tert-butyloxycarbonyle epin-dolidione.

4. Procédé selon l'une des revendications 1 à 3, **caractérisé en ce que** les groupes de protection tert-butyloxycarbonyle sont détachés de la tert-butyloxycarbonyle epin-dolidione par un réchauffement de la couche appliquée sur le support.

5. Procédé selon l'une des revendications 1 à 4, **caractérisé en ce que** les groupes de protection tert-butyloxycarbonyle sont détachés la tert-butyloxycarbonyle epin-dolidione par un traitement de la couche appliquée sur le support avec de la vapeur acide.

6. Procédé selon la revendication 5, **caractérisé en ce qu'**un acide trifluoroacétique évaporé est utilisé en tant que vapeur acide.

7. Procédé selon l'une des revendications 1 à 6, **caractérisé en ce qu'**au moins un solvant parmi le groupe des solvants contenant du chloroforme, chlorobenzène, toluène, dichlorométhane, cyclohexane et acétone est utilisé en tant que solvant pour la tert-butyloxycarbonyle epin-dolidione.
